# EUROPÄISCHE PATENTSCHRIFT

(11) **EP 1 530 778 B1**
(45) Veröffentlichungstag und Bekanntmachung des Hinweises auf die Patenterteilung: **28.02.2007**
(21) Anmeldenummer: 03790669.0
(22) Anmeldetag: 01.08.2003
(51) Int. Cl.: G06K 19/07

(54) **VERFAHREN ZUM REGELN DES EINGANGSSIGNALS EINES KONTAKTLOS-TRANSPONDERS**
METHOD FOR REGULATING THE INPUT SIGNAL OF A NON-CONTACT TRANSPONDER
PROCEDE POUR REGULER UN SIGNAL D'ENTREE D'UN TRANSPONDEUR SANS CONTACT

(30) Priorität: 22.08.2002 DE 10238592; 05.11.2002 DE 10251459
(43) Veröffentlichungstag der Anmeldung: 18.05.2005
(73) Patentinhaber: Infineon Technologies AG, 81669 München (DE)
(72) Erfinder: ALIHODZIC, Admir, A-8010 Graz (AT); KARGL, Walter, A-8020 Graz (AT); MISSONI, Albert, A-8010 Graz (AT)
(74) Vertreter: Epping - Hermann - Fischer
(86) Internationale Anmeldenummer: PCT/DE2003/002599
(87) Internationale Veröffentlichungsnummer: WO 2004/021270

(56) Entgegenhaltungen:
- WO-A-01/71997
- WO-A-02/082634
- US-A- 6 031 419

## Beschreibung

Die Erfindung betrifft ein Verfahren zum Regeln des Eingangssignals eines Kontaktlos-Transponders gemäß Patentanspruch 1.

Beim Kontaktlos-Transponder, wie sie beispielsweise für kontaktlose Chipkarten oder kontaktlose Tags verwendet werden, wird häufig eine sogenannte ASK-Modulation eingesetzt. Man versteht hierunter ein hochfrequentes Signal, das mit in digitaler Form vorliegenden Daten zwischen einem ersten und zweiten Pegel wechselt und somit moduliert ist.

So wie bei digitalen Daten zwischen "ja" und "nein" oder "1" und "0" oder "high" und "low" unterschieden wird, wird zwischen einer hohen und einer niedrigen Amplitude unterschieden. Derzeit sind zwei unterschiedliche Modulationsarten gebräuchlich, nämlich ASK 100 und ASK 10. ASK 100 weist dabei einen Pegelunterschied von 100 % und ASK 10 einen Pegelunterschied von 10 % auf.

Ein Problem der ASK-Modulation ist darin zu sehen, daß es auch durch eine Änderung des Abstands zwischen Sender und Empfänger das so modulierte Signal bei gleichbleibender Amplitude des ausgesendeten Signals empfängerseitig zu einer Änderung der empfangenen Amplitude kommt. Gleiches gilt, wenn im Zwischenraum zwischen Sender und Empfänger sich das Medium ändert. Um dieses Problem zu umgehen, wird, wie in der EP 0398943 B1 angegeben, empfängerseitig ein sogenannter "Shunt-Regler" eingesetzt, mit dem vor dem Demodulator die Eingangssignalamplitude geregelt wird.

Nachteilig an der in dieser Druckschrift beschriebenen Anordnung ist es, daß beim Vorhandensein eine Signalpause, beispielsweise nach einem Übergang von "high" auf "low", ein solcher Regler versucht, den Pegelunterschied, der durch die zu übertragende Information erzeugt wird, wegzuregeln. Um dies zu umgehen, wird bereits zumindest firmenintern davon ausgegangen, daß nach dem Erkennen eines Signalübergangs von "high" nach "low", die Regelverstärkung auf einen Wert vor dem Signalübergang eingefroren wird. Sobald ein erneuter Signalübergang zurück von "low" nach "high" erkannt wird, wird das Einfrieren der Regelverstärkung aufgehoben und der Regler arbeitet uneingeschränkt weiter.

Diese Maßnahme hat wiederum den Nachteil, daß am Ende eines "low"/"high"-Übergangs die Regelverstärkung so lange angehoben wird, bis die hohe Amplitude erreicht ist. Sobald die hohe Amplitude erreicht ist, wird die Regelverstärkung wieder herabgesetzt. Eine derartige Maßnahme führt jedoch leicht zu einem Regelüberschwingen. Ein derartiges Überschwingen kann wiederum dazu führen, daß eine Zustandsänderung, d. h. ein Signalübergang von "high" nach "low" vom Demodulator erkannt wird, der wiederum gar nicht vorliegt. Eine solche Signal-übergangserkennung würde schließlich zu fehlerhaften Daten führen.

Aus der WO 01/71997 A ist ein Verfahren zum Regeln des Eingangssignals eines Kontaktlos-Transponders bekannt, bei dem die Signalstärke eines amplitudenmodulierten Eingangssignals auf einen Sollwert geregelt wird.

Aus der WO 02/082634 A ist ein übliches Verfahren zum Demodulieren von ASK-modulierten Signalen beschrieben.

Weiterhin ist aus der WO 01/71997 A ein Verfahren zum Erkennen von Modulationslücken in ASK-modulierten Signalen bekannt, bei dem die Modulationslücke anhand fallender Flanken und einem sich daran anschließenden Minimum detektiert wird.

Der Erfindung liegt folglich die Aufgabe zugrunde, ein Verfahren zum Regeln des Eingangssignals von Kontaktlos-Transpondern vorzusehen, bei dem mit hoher Zuverlässigkeit das Eingangssignal so geregelt wird, daß das Signal mit hoher Zuverlässigkeit detektierbar ist.

Diese Aufgabe wird erfindungsgemäß mit den in Patentanspruch 1 angegebenen Maßnahmen gelöst.

Dadurch, daß nach dem Erkennen des Endes einer Modulationslücke die in der Modulationslücke "eingefrorene" Regelung erst nach einem vorgegebenen Intervall freigegeben wird, wird sichergestellt, daß die Regelung mit der Bezugsgröße der hohen Amplitude als "Ist-Wert" die Regelung aufnimmt.

Weitere vorteilhafte Ausgestaltungen der Erfindung sind in den untergeordneten Ansprüchen angegeben.

Es zeigen:
- Figur 1: ein typisches Eingangssignal,
- Figur 2: ein Fensterdetektor,
- Figur 3: einen typischen zu detektierenden Signalverlauf,
- Figur 4: eine übliche Detektionsschaltung,
- Figur 5: eine Reglerschaltung.

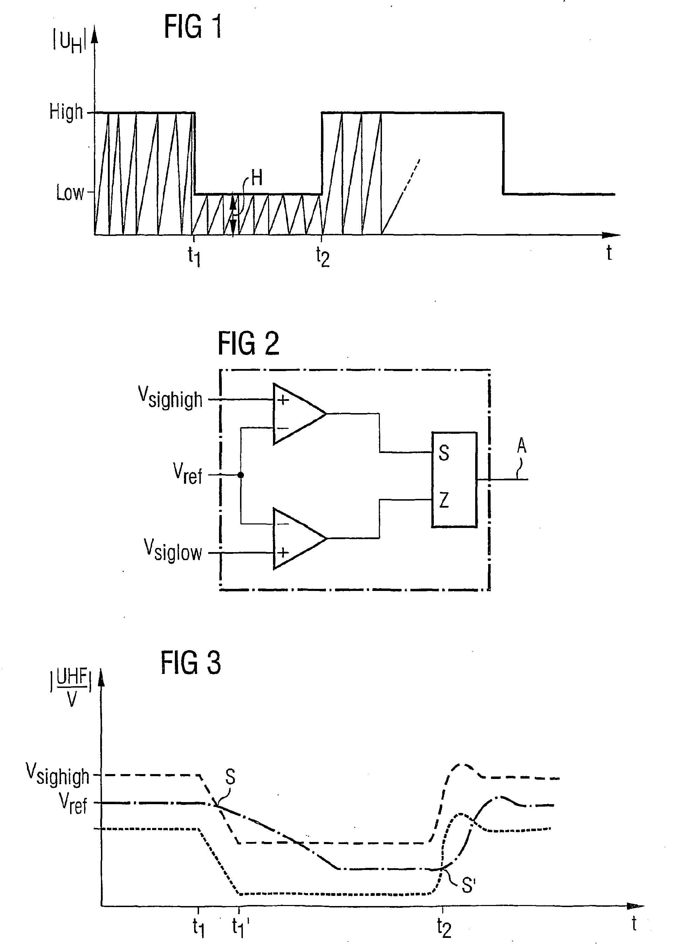

Figur 1 zeigt in symbolischer Form ein hochfrequentes, betragsmäßig dargestelltes Eingangssignal, das "ASK"-moduliert ist. Es handelt sich dabei um ein hochfrequentes Eingangssignal mit der Amplitude "high", das zwischen den Zeitpunkten t₁ und t₂ auf einem geringeren Amplitudenwert "low" moduliert wird. Der Abschnitt zwischen den Zeitpunkten t₁ und t₂, bei dem die Amplitude den niedrigen Amplitudenwert "low" aufweist, wird auch Modulationslücke genannt.

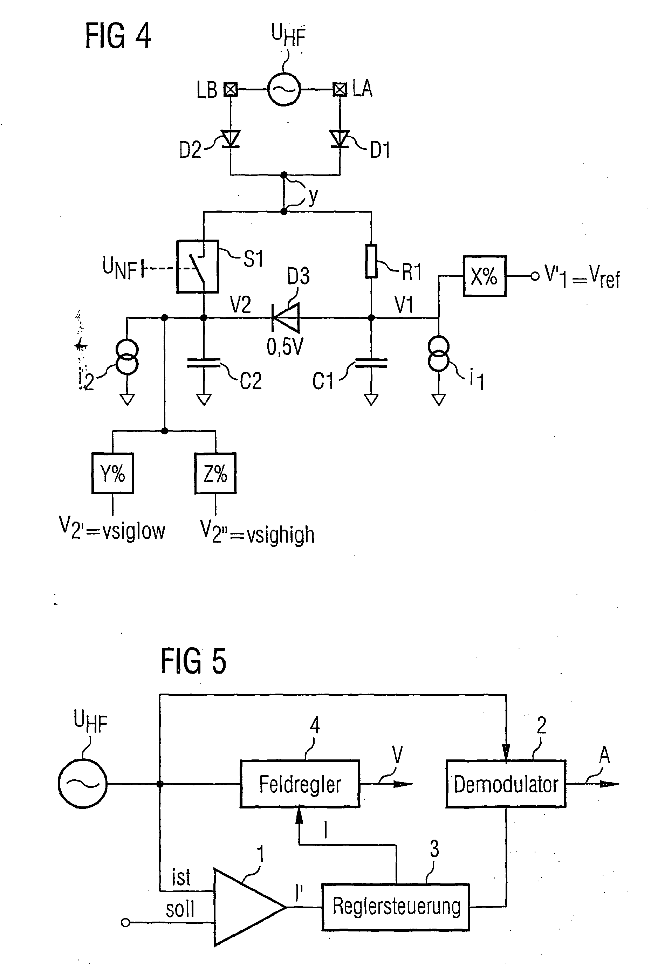

Gemäß einer in Figur 4 dargestellten Schaltungsanordnung wird das hochfrequente Signal detektiert. Dabei werden, während das Signal die Amplitude "high" aufweist, die beiden Kondensatoren C1 und C2 aufgeladen. Fällt die Amplitude auf den Wert "low", öffnet sich der Schalter S1 und die Kondensatoren C1 und C2 werden über die jeweils zugeordneten Stromquellen E1 und E2 entladen, wobei unterschiedliche Zeitkonstanten vorgesehen sind. Aus dem Spannungsverlauf des Kondensators C1 wird die Referenzspannung Vref gewonnen, wobei die Entscheidungsgrößen über unterschiedliche Spannungsteiler als Signale V_{siglow} und V_{sighigh} vom Spannungsverlauf am Kondensator C2 abgeleitet werden. Diese werden einer Fensterschaltung zugeführt, die in Figur 2 dargestellt ist. Die Funktion dieser Fensterschaltung wird am in Figur 3 dargestellten Kurvenverlauf nachfolgend erläutert.

Wie bereits unter Bezugnahme auf Figur 1 erläutert, erfolgt zum Zeitpunkt t₁ ein Signalübergang vom hohen Potential zum niedrigen Potential. Durch geeignete Wahl der Spannungsteiler liegt das Signal V_{sighigh} oberhalb der Bezugsgröße Vref und das Signal V_{siglow} unterhalb der Bezugsgröße Vref. Durch die unterschiedlichen Zeitkonstanten schneidet nunmehr zum Zeitpunkt t_{1'} die Kurve des Signals V_{sighigh} die Kurve der Bezugsgröße Vref, was mit dem Schnittpunkt S bezeichnet ist. Dieser Schnittpunkt S wird mit der Fensterschaltung, die in Figur 2 dargestellt ist, als Vorliegen der niedrigen Amplitude am Ausgang A angegeben. Entsprechend führt der Übergang von der niedrigen Amplitude zur hohen Amplitude zum Zeitpunkt t₂ zu einem Schnittpunkt S' zwischen dem Signal V_{siglow} und der Bezugsgröße Vref. Dies wird ebenfalls durch Signalisierung des hohen Amplitudenzustands am Ausgang A angezeigt.

Damit die in Figur 4 dargestellte Demodulatorschaltung, der die Fensterschaltung gemäß Figur 2 nachgeschaltet ist, störungsfrei arbeitet, wird die Versorgungsspannung V für die Schaltungsanordnung mit der in Figur 5 dargestellten Regelschaltung geregelt. Der Spannungsbzw.Feldregler 4 liefert eine auf einen vorgegebenen Wert festgelegte Versorgungsspannung V, mit der die restliche Schaltungsanordnung betrieben wird. Der Wert der vom Eingangsregler 1 erzeugten Stellgröße I' wird von einer Reglersteuerung 3 als Stellgröße I für den Spannungsregler 4 im Verhältnis zur vorgegebenen Sollgröße und in Abhängigkeit, davon, welchen Modulationspegel der Demodulator ermittelt hat, aus. Wird vom Demodulator2 eine Modulationslücke erkannt, so wird von der Reglersteuerung 3 weiterhin das vor der Demodulationslücke bestehende Eingangssignal I weiter dem Spannungsregler 4 zugeführt, unabhängig vom Wert der Ausgangsgröße I' des Eingangsreglers 1. Am Ende einer Demodulationslücke gibt die Reglersteuerung 3 die Ausgangsgröße I' des Eingangsreglers 1 erst nach Ablauf eines Zeitabschnitts als Eingangssignal I an den Feldregler weiter, wenn davon ausggegangen wird, daß die Modulation den Wert "high" erreicht hat.

Würde die Regelverstärkung am Punkt S', wenn nämlich der Übergang von der niedrigen Amplitude zur hohen Amplitude erkannt wird, freigegeben werden, würde dies zumindest zu einem Durchschwingen der Kurvenverläufe von V_{sighigh} und V_{siglow} zur Folge haben. Der Regler würde durch den niedrigen Amplitudenwert die Regelverstärkung erhöhen, so daß die Spannung über den Anschlüssen LA und LB oder am Knoten Y erhöht würde. Dies würde jedoch durch das anhaltende Ansteigen der Eingangsspannung auf Grund einer notwendigen geringen Regelzeitkonstanten zu einer Überhöhung führen. Daraufhin würde der Regler die Verstärkung vermindern, so daß es zu einem Durchschwingen kommen würde. Dies würde wiederum zu einem Schnittpunkt zwischen der Kurve V_{sighigh} und der langsam ansteigenden Kurve des Signals Vref führen. Ein derartiger Schnittpunkt würde am Demodulatorausgang als Übergang von der hohen Amplitude zur niedrigen Amplitude erkannt werden, was tatsächlich nicht vorliegt.

Aus diesem Grund wird von der Reglersteuerung 3 die Regelverstärkung über den Punkt S' hinaus festgehalten und erst zu einem späteren Zeitpunkt freigegeben. Dieses Zeitintervall ist so weit zu legen, daß davon ausgegangen wird, daß die Eingangsamplitude ausreichend angestiegen ist. Das Festhalten der Regelverstärkung über den Punkt S' hinaus darf jedoch nur so lange erfolgen, daß vor einem möglichen erneuten Wechsel von der hohen Amplitude zur niedrigen Amplitude der Regler freigegeben ist.

Dieses Zeitintervall hängt folglich von der minimalen Periode des modulierenden Signals ab.

### Bezugszeichenliste

- 1: Eingangsregleregler
- 2: Demodulator
- 3: Reglersteuerung
- 4: Feldregler
- UHF: Eingangssignal
- Vsighigh: hohes Erkennungssignal
- Vsiglow: niedriges Erkennungssignal
- Vref: Bezugsgröße
- I: Eingangssignal
- I': Ausgangsgröße

## Patentansprüche

1. Verfahren zum Regeln des Eingangssignals eines Kontaktlos-Transponders, bei dem die Signalstärke eines amplitudenmodulierten Eingangssignals auf einen Sollwert geregelt wird,
**dadurch gekennzeichnet, dass** bei Erkennen einer Modulationslücke durch die Demodulationseinrichtung, die Regelung der Regelverstärkung zum Zeitpunkt vor der Modulationslücke festgelegt wird und bei Erkennen des Endes der Modulationslücke nach einem vorbestimmten Intervall die Regelung freigegeben wird.

2. Verfahren nach Anspruch 1, bei dem das vorbestimmte Intervall so lange dauert, bis die Signalamplitude des Eingangssignals auf den Wert vor der Modulationslücke angestiegen ist.

3. Verfahren nach Anspruch 2, bei dem das vorbestimmte Intervall kürzer als der minimale Abstand zweier Modulationslücken ist.

## Claims

1. Method for controlling the input signal for a contactless transponder, in which the signal strength of an amplitude-modulated input signal is controlled to a nominal value, **characterized in that** identification of a modulation gap by the demodulation device involves the control for the controller gain at the time before the modulation gap being stipulated, and identification of the end of the modulation gap involves the control being released after a predetermined interval.

2. Method according to Claim 1, in which the predetermined interval lasts until the signal amplitude of the input signal has risen to the value before the modulation gap.

3. Method according to Claim 2, in which the predetermined interval is shorter than the minimum distance between the two modulation gaps.

## Revendications

1. Procédé de régulation du signal d'entrée d'un transpondeur sans contact, dans lequel on règle à une valeur de consigne l'intensité d'un signal d'entrée modulé en amplitude, **caractérisé en ce que**, si une lacune de modulation est détectée par le dispositif de démodulation, on fixe la régulation de l'amplification de régulation à l'instant avant la lacune de modulation et, lors de la détection de la fin de la lacune de modulation, on libère la régulation après un intervalle déterminé à l'avance.

2. Procédé suivant la revendication 1, dans lequel l'intervalle déterminé à l'avance dure jusqu'à ce que l'amplitude du signal d'entrée s'élève à la valeur avant la lacune de modulation.

3. Procédé suivant la revendication 2, dans lequel l'intervalle déterminé à l'avance est plus court que la distance minimum entre deux lacunes de modulation.
